(19) **Europäisches Patentamt / European Patent Office / Office européen des brevets**

(11) **EP 2 026 319 B1**

(12) **EUROPEAN PATENT SPECIFICATION**

(45) Date of publication and mention
of the grant of the patent:
**10.04.2013 Bulletin 2013/15**

(51) Int Cl.:
***G09G 3/32*** *(2006.01)*

(21) Application number: **08161175.8**

(22) Date of filing: **25.07.2008**

(54) **Organic light emitting display and method of driving the same**

Organische lichtemittierende Anzeige und Verfahren zu ihrer Ansteuerung

Affichage électroluminescent organique et son procédé de commande

(84) Designated Contracting States:
**DE FR GB HU**

(30) Priority: **27.07.2007 KR 20070075428**

(43) Date of publication of application:
**18.02.2009 Bulletin 2009/08**

(73) Proprietor: **Samsung Display Co., Ltd.**
**Yongin-City, Gyeonggi-Do, 446-711 (KR)**

(72) Inventor: **Kwon, Oh-Kyong**
**Seoul (KR)**

(74) Representative: **Walaski, Jan Filip et al**
**Venner Shipley LLP**
**200 Aldersgate**
**London**
**EC1A 4HD (GB)**

(56) References cited:
**EP-A- 1 282 101**   **EP-A1- 0 905 673**
**WO-A-2005/015530**   **WO-A-2006/063448**
**US-A1- 2003 057 895**

**Description**

The present invention relates to an organic light emitting display and a driving method thereof.

Recently, various flat panel displays that have reduced weight and volume in comparison to cathode ray tubes (CRTs) have been developed. Flat panel displays include liquid crystal displays (LCDs), field emission displays (FEDs), plasma display panels (PDPs), and organic light emitting displays.

Among the flat panel displays, the organic light emitting displays make use of organic light emitting diodes that emit light by re-combination of electrons and holes. The organic light emitting display has advantages of high response speed and low power consumption.

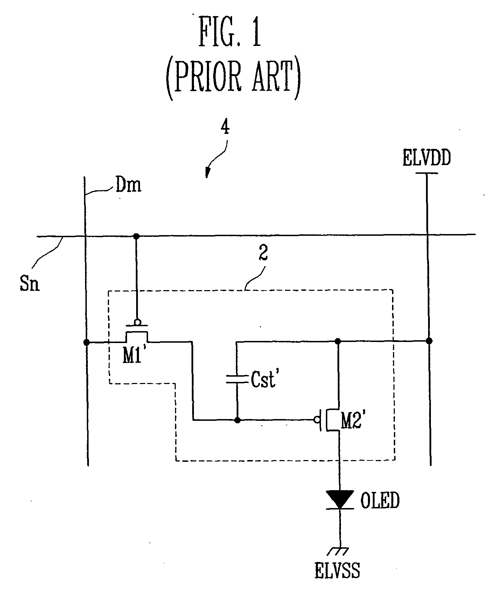

FIG. 1 is a circuit diagram showing a pixel of a conventional organic light emitting display.

With reference to FIG. 1, a pixel 4 of an organic light emitting display includes an organic light emitting diode OLED and a pixel circuit 2. The pixel circuit 2 is coupled to a data line Dm and a scan line Sn, and controls the organic light emitting diode OLED.

An anode electrode of the organic light emitting diode OLED is coupled to the pixel circuit 2, and a cathode electrode of the organic light emitting diode OLED is coupled to a second power source ELVSS. The organic light emitting diode OLED generates light of a luminance corresponding to an electric current from the pixel circuit 2.

When a scan signal is supplied to the scan line Sn, the pixel circuit 2 controls an amount of electric current provided to the organic light emitting diode OLED corresponding to a data signal provided to the data line Dm. In order to do this, the pixel circuit 2 includes a second transistor M2', a first transistor M1', and a storage capacitor Cst'. The second transistor M2' is coupled between a first power source ELVDD and the organic light emitting diode OLED. The first transistor M1' is coupled between the data line Dm and the scan line Sn. The storage capacitor Cst' is coupled between a gate electrode and a first electrode of the second transistor M2'.

A gate electrode of the first transistor M1' is coupled to the scan line Sn, and a first electrode of the first transistor M1' is coupled to the data line Dm. A second electrode of the first transistor M1' is coupled with one terminal of the storage capacitor Cst'. Here, the first electrode is a source electrode or a drain electrode, and the second electrode is the other one of the source electrode or the drain electrode. For example, when the first electrode is the source electrode, the second electrode is the drain electrode. When a scan signal is supplied to the first transistor M1' coupled with the scan line Sn and the data line Dm, the first transistor M1' is turned on to provide a data signal from the data line Dm to the storage capacitor Cst'. At this time, the storage capacitor Cst' is charged with a voltage corresponding to the data signal.

A gate electrode of the second transistor M2' is coupled to one terminal of the storage capacitor Cst', and a first electrode of the second transistor M2' is coupled to another terminal of the storage capacitor Cst' and a first power source ELVDD. Further, a second electrode of the second transistor M2' is coupled with an anode electrode of the organic light emitting diode OLED. The second transistor M2' controls an amount of electric current flowing from the first power source ELVDD to a second power source ELVSS through the organic light emitting diode OLED according to the voltage charged in the storage capacitor Cst'. At this time, the organic light emitting diode OLED emits light corresponding to the amount of electric current supplied from the second transistor M2'.

However, the conventional organic light emitting display may not always display images of desired luminance because of an efficiency change resulting from the degradation of the organic light emitting diodes OLEDs. In practice, as time elapses, the organic light emitting diodes OLEDs are degraded. As the organic light emitting diode OLED is degraded, light of gradually decreasing luminance is generated in response to the same data signal.

Accordingly, it is an aspect of an exemplary embodiment according to the present invention to provide an organic light emitting display and a method for driving the same, which may compensate for the degradation of organic light emitting diodes. The organic light emitting display may display images having substantially uniform luminance regardless of temperature and/or resistance changes of the organic light emitting diodes.

WO2006/063448 discloses a method and system for programming, calibrating and driving a light emitting device. US2003/0057895 discloses a light emitting device and method of driving the device, while EP 0 905 673 discloses an active matrix display and driving method.

US2003057895 discloses a system that specifies the characteristic of a deriving transistor provided in a pixel and corrects a video signal to be inputted to the pixel based on the specification. This document aims to provide a light emitting device and its driving method in which a change with age in amount of current flowing between two electrodes of a light emitting element is reduced to obtain clear multi-gray scale display.

According to a first aspect of the invention, there is provided an organic light emitting display as set out in claim 1. Preferred features of this aspect are set out in claims 2 to 11.

According to a first aspect of the invention, there is provided a method of driving the organic light emitting display as set out in claim 12. Preferred features of this aspect are set out in claims 13 to 15.

These and/or other embodiments and features of the invention will become apparent and more readily appreciated from the following description of certain exemplary embodiments, taken m conjunction with the accompanying drawings of which:

FIG. 1 is a circuit diagram of a pixel of a conventional organic light emitting display;

FIG. 2 is a block diagram showing an organic light emitting display according to an embodiment of the present invention;

FIG. 3 is a circuit diagram showing one example of the pixel shown in FIG. 2;

FIG. 4 is a block diagram showing one example of the data driver shown in FIG. 2;

FIG. 5 is a schematic diagram showing a connected construction of the sensing unit, the data driver, the timing controller, and the pixel shown in FIG. 2;

FIG. 6A through FIG. 6C are schematic diagrams that illustrate a method for driving an organic light emitting display in association with a drive waveform; and

FIG. 7 is a block diagram showing an organic light emitting display according to another embodiment of the present invention.

Hereinafter, certain exemplary embodiments according to the present invention will be described with reference to the accompanying drawings. Here, when a first element is described as being coupled to a second element, the first element may be directly coupled to the second element, or may be indirectly coupled to the second element via a third element. Further, some of the elements that are not essential to the complete understanding of the invention are omitted for clarity. Also, like reference numerals refer to like elements throughout.

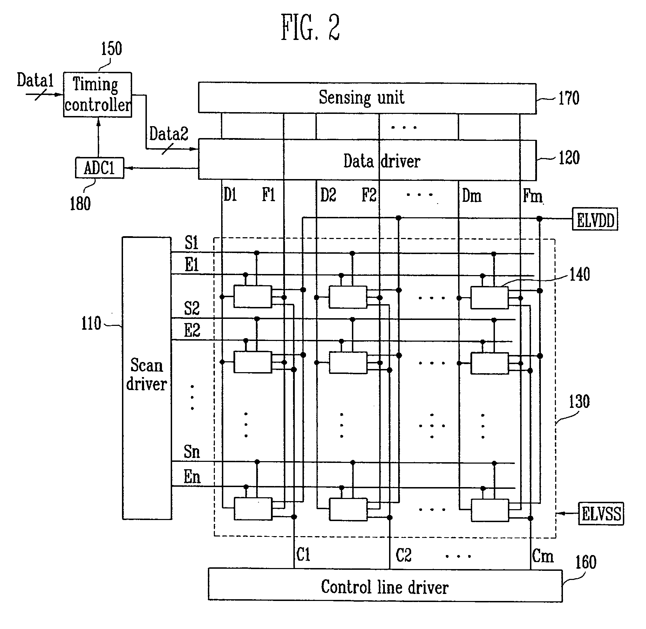

Hereinafter, exemplary embodiments of the present invention will be described with reference to FIG. 2 to FIG. 7.

FIG. 2 is a block diagram showing an organic light emitting display according to an embodiment of the present invention. While FIG. 2 shows a sensing unit 170 and a data driver 120 as two separate components, in practice, they can be formed on a single chip together.

With reference to FIG. 2, the organic light emitting display according to the embodiment of the present invention includes a display region 130 including pixels 140, a scan driver 110, a control line driver 160, a data driver 120, and a timing controller 150. The pixels 140 are coupled to scan lines S1 through Sn, emission control lines E1 through En, data lines D1 through Dm, feedback lines F1 through Fm, and control lines C1 to Cm. The scan driver 110 drives the first scan lines S1 through Sn and the emission control lines E1 through En. The control line driver 160 drives the control lines C1 through Cm. The data driver 120 drives the data lines D1 through Dm. The timing controller 150 controls the scan driver 110, the control line driver 160, and the data driver 120.

The organic light emitting display according to the described embodiment of the present invention further includes a sensing unit 170 and a first analog-digital converter 180 (referred to as 'ADC1' hereinafter). The sensing unit 170 is coupled with the feedback lines F1 through Fm, and extracts degradation information of the organic light emitting diode OLED included in each of the pixels 140. The ADC1 180 converts the degradation information of the organic light emitting diode extracted by the sensing unit 170 to a digital signal, and transfers the digital signal to the timing controller 150.

The display region 130 includes the pixels 140, which are disposed at crossing regions of the scan lines S1 through Sn, the emission control lines E1 through En, the data lines D1 through Dm, the feedback lines F1 through Fm, and the control lines C1 through Cm. The pixels 140 charge a voltage (e.g., a predetermined voltage) corresponding to a data signal, and supply an electric current corresponding to the charged voltage to the organic light emitting diode to generate light of corresponding luminance (e.g., predetermined luminance). To do this, each of the pixels 140 is coupled to a first power source ELVDD and a second power source ELVSS. In the described embodiment, the second power source ELVSS has a voltage that is lower than that of the first power source ELVDD.

The scan driver 110 supplies a scan signal to the scan lines S1 through Sn under a control of the timing controller 150. Further, the scan driver 110 supplies an emission control signal to the emission control lines E1 through En under a control of the timing controller 150.

The control line driver 160 supplies a control signal to the control lines C1 through Cm under a control of the timing controller 150. Here, the control line driver 160 sequentially supplies a control signal to the control lines C1 through Cm so that pixels 140 positioned on the same horizontal line can be coupled to the sensing unit 170 at different times.

The sensing unit 170 extracts a voltage applied to the organic light emitting diode, namely, degradation information of the organic light emitting diode, while supplying a current (e.g., predetermined current) to the organic light emitting diode included in each of the pixels 140. Further, the sensing unit 170 supplies a first digital value and a second digital value to the data driver 120 according to the extracted voltage. The data driver 120 supplies a data signal to the data lines D1 through Dm under a control of the timing controller 150 during a normal driving period. Further, the data driver 120 sequentially converts the first digital value and the second digital value supplied from the sensing unit 170 to analog voltages during the sensing period, and provides the analog voltages to the pixels 140. At this time, the data driver 120 provides a voltage applied to a gate electrode of a drive transistor of the pixel 140 to the ADC1 180.

The ADC1 180 converts a voltage supplied from the data driver 120 to a fourth digital value corresponding the first digital value, and converts the voltage supplied from the data driver 120 to a fifth digital value corresponding the second digital value, during the sensing period. Next, the ADC1 180 provides the fourth digital value and the fifth digital value to the timing controller 150.

The timing controller 150 controls the scan driver 110, the data driver 120, and the control line driver 160. Further, the timing controller 150 changes a bit value of an externally provided first data Data1 using the fourth and fifth digital values supplied from the ADC1 180 to generate a second data Data2. The bit value of the second data Data2 is set so that the degradation of an organic light emitting diode included in a pixel 140 to receive a data signal corresponding to the second data Data2 and a mobility and a threshold voltage of a drive transistor in the pixel 140 can be compensated. The second data Data2 generated by the timing controller 150 is supplied to the data driver 120. When the data driver 120 receives the second data Data2, it generates a data signal and provides it to the pixels 140.

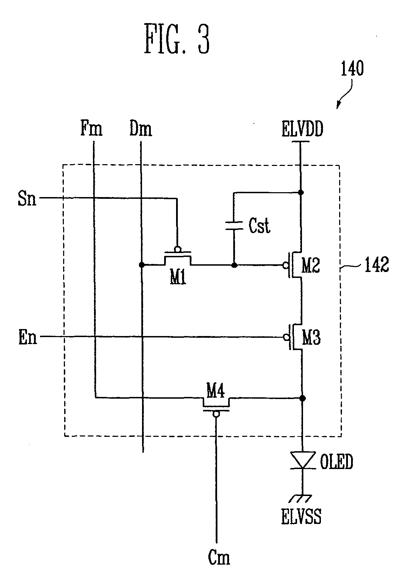

FIG. 3 is a circuit diagram showing an example of the pixel shown in FIG. 2. For the convenience of description, FIG. 3 shows the pixel 140 coupled to the m-th data line Dm and the n-th scan line Sn.

With reference to FIG. 3, the pixel 140 according to the described embodiment of the present invention includes an organic light emitting diode OLED and a pixel circuit 142. The pixel circuit 142 supplies an electric current to the organic light emitting diode OLED.

An anode electrode of the organic light emitting diode OLED is coupled with the pixel circuit 142, and a cathode electrode of the organic light emitting diode OLED is coupled with the second power source ELVSS. The organic light emitting diode OLED generates light of a luminance (e.g., a predetermined luminance) corresponding to an electric current from the pixel circuit 142.

The pixel circuit 142 provides degradation information of the organic light emitting diode OLED to the sensing unit 170 during a first period of a sensing period. Further, the pixel circuit 142 provides a voltage applied to a gate electrode of the second transistor M2 to the ADC1 180 through a data line Dm during a second period of the sensing period. To do this, the pixel circuit 142 includes four transistors M1 through M4, and a storage capacitor Cst.

A gate electrode of the first transistor M1 is coupled with the scan line Sn, and a first electrode of the first transistor M1 is coupled with a data line Dm. A second electrode of the first transistor M1 is coupled with a first terminal of the storage capacitor Cst. The first transistor M1 is turned on when a scan signal is supplied to the scan line Sn (i.e., when the scan signal has a low level).

A gate electrode of the second transistor M2 is coupled to the first terminal of the storage capacitor Cst, and a first electrode of the second transistor M2 is coupled to a second terminal of the storage capacitor Cst. Further, a second electrode of the second transistor M2 is coupled with a first electrode of the third transistor M3. The second transistor M2 provides an electric current corresponding to a voltage stored in the storage capacitor Cst to the organic light emitting diode OLED.

A gate electrode of the third transistor M3 is coupled with an emission control line En, and a first electrode of the third transistor M3 is coupled with the second electrode of the second transistor M2. Further, a second electrode of the third transistor M3 is coupled with the organic light emitting diode OLED. When the emission control signal is supplied to the emission control line En (i.e., when the emission control signal has a high level), the third transistor M3 is turned off. In contrast to this, when the emission control signal is not supplied to the emission control line En (i.e., when the emission control signal has a low level), the third transistor M3 is turned on.

A gate electrode of the fourth transistor M4 is coupled to the control line Cm, and a first electrode of the fourth transistor M4 is coupled to an anode electrode of the organic light emitting diode OLED. Further, a second electrode of the fourth transistor M4 is coupled to a feedback line Fm. The fourth transistor M4 is turned on when a control signal is supplied to the control line Cm.

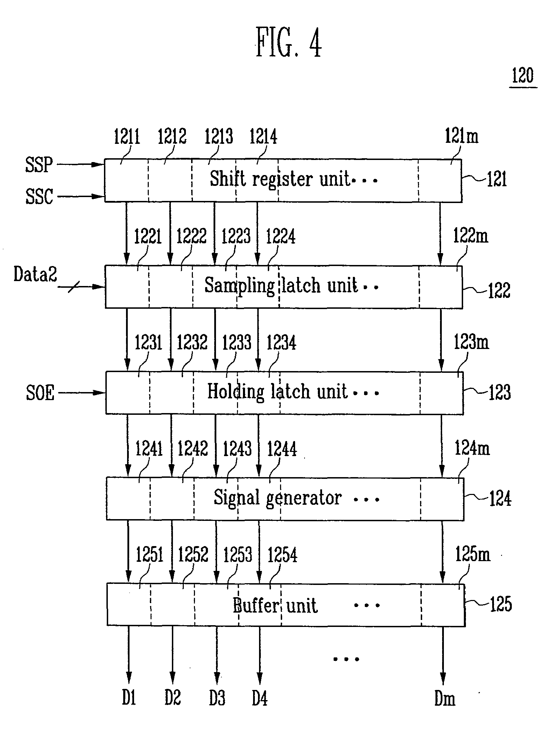

FIG. 4 is a block diagram showing the data driver shown in FIG. 2. With reference to FIG. 4, the data driver 120 includes a shift register unit 121, a sampling latch unit 122, a holding latch unit 123, a signal generator 124, and a buffer unit 125.

The shift register unit 121 receives a source start pulse SSP and a source shift clock SSC from a timing controller 150. When the shift register unit 121 receives the source start pulse SSP and the source shift clock SSC, it sequentially outputs m sampling signals while shifting the source start pulse SSP every period of the source shift clock SSC. In order to do this, the shift register unit 121 includes m shift registers 1211 through 121m.

The sampling latch unit 122 sequentially stores second data Data2 in response to the sampling signals, which are sequentially supplied from the shift register unit 121. In order to do this, the sampling latch unit 122 includes m sampling latches 1221 through 122m to store m second data Data2.

The holding latch unit 123 receives a source output enable signal SOE from the timing controller 150. When the holding latch unit 123 receives a source output enable signal SOE, it receives and stores data Data from the sampling latch unit 122. Further, the holding latch unit 123 supplies the data Data stored therein to the signal generator 124. To do this, the holding latch unit 123 includes m holding latches 1231 through 123m.

The signal generator 124 receives the second data Data2 from the holding latch unit 123, and generates m data signals corresponding to the received second data Data2. In order to do this, the signal generator 124 includes m digital-analog converters (referred to as "DAC") 1241 through 124m. That is, the signal generator 124 generates m data signals using the DACs 1241 through 124m positioned at respective channels, and provides the m data signals to the buffer unit 125.

Further, each of the DACs 1241 through 124m is coupled with the sensing unit 170. The DACs 1241 through 124m convert a voltage supplied from the sensing unit 170 to an analog voltage, and provide the analog voltage to the buffer unit 125.

The buffer unit 125 provides the m data signals from the signal generator 124 to m data lines D1 through Dm. To do this, the buffer unit 125 includes m buffers 1251 through 125m. In one exemplary embodiment, the m buffers 1251 through 125m are constructed by an operational amplifier. In the described embodiment, a polarity of input terminals of the operational amplifier can be inverted according to a control signal (not shown). That is, a polarity of a positive polarity input terminal can be inverted to a polarity of a negative polarity input terminal, and a polarity of a negative polarity input terminal can be inverted to a polarity of the positive polarity input terminal. Further, the operational amplifier functions as a comparator or a buffer according to a turning-on/off of a switch (not shown).

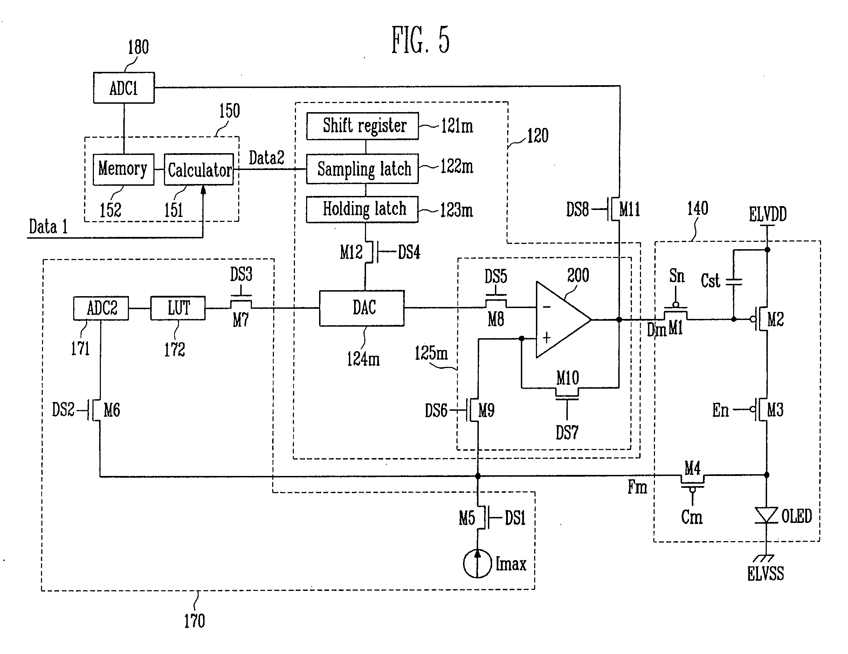

FIG. 5 is a schematic diagram showing a connected construction of the sensing unit 170, the data driver 120, the timing controller 150, and one of the pixels 140 shown in FIG. 2.

With reference to FIG. 5, the sensing unit 170 includes a current source Imax, a second analog-digital converter (referred to as "ADC2" hereinafter) 171, and a look up table (referred to as "LUT" hereinafter) 172.

The current source Imax is coupled to each of the feedback lines F1 through Fm, and supplies an electric current (e.g., a predetermined electric current) to the organic light emitting diode OLED. Here, the electric current supplied from the current source Imax to the organic light emitting diode OLED is experimentally determined so that degradation information of the organic light emitting diode OLED may be sufficiently extracted. In practice, the electric current supplied from the current source Imax to the organic light emitting diode OLED is determined by a size and a resolution of a panel. For example, the electric current supplied from the current source Imax to the organic light emitting diode OLED may be set to range from 50 nA to 50 $\mu$A.

A fifth transistor M5 is located between the current source Imax and the organic light emitting diode OLED. The fifth transistor M5 is turned on during a first period of the sensing period.

The ADC2 171 is coupled to the feedback lines F1 through Fm in common. When an electric current from the current source Imax is supplied to the ADC2 171, it converts a voltage applied to the organic light emitting diode OLED to a third digital value, and provides the third digital value to the LUT 172. A sixth transistor M6 is located between the ADC2 171 and the organic light emitting diode OLED. The sixth transistor M6 is turned on during the first period of the sensing period. Here, the ADC2 171 and the LUT 172 are coupled to all channels in common. The LUT 172 transfers a first digital value and a second digital value to the DAC 124m at an interval (e.g., a predetermined interval) corresponding to a third digital value supplied from the ADC2 171. In more detail, the third digital value supplied from the ADC2 171 to the LUT 172 includes degradation information of the organic light emitting diode OLED. In other words, when an electric current from the current source Imax is supplied to the organic light emitting diode OLED, a voltage applied to the organic light emitting diode OLED increases as degradation of the organic light emitting diode OLED progresses. Accordingly, the third digital value supplied from the ADC2 171 to the LUT 172 includes degradation information of the organic light emitting diode OLED.

The LUT 172 provides the first digital value and the second digital value to the DAC 124m at an interval (e.g., a predetermined interval) corresponding to the third digital value supplied from the ADC2 171. Here, the first digital value compensates for the degradation of the organic light emitting diode OLED. The second digital value has voltage information that is different from that of the first digital value. Here, the first digital value is set as a value corresponding to a voltage, which is applied to an anode electrode of the organic light emitting diode OLED degraded, to compensate for the degradation of the organic light emitting diode OLED. For example, the first digital value may be set as a value corresponding to a voltage, which may express luminance of a maximum gradation by the degraded organic light emitting diode OLED. Accordingly, the first digital value includes voltage information to be applied to an anode electrode of the organic light emitting diode OLED, namely, to be increased in order to compensate for a reduction of an emission efficiency in the organic light emitting diode OLED corresponding to the third digital value.

The second digital value includes voltage information that is lower than that of the first digital value. For example, the second digital value is set as a value corresponding to voltage information capable of generating one fourth the luminance of the luminance corresponding to the first digital value or a voltage capable of expressing luminance of a minimum gradation by the organic light emitting diode OLED. Hereinafter, for the convenience of description, it is assumed that the second digital value includes voltage information capable of generating one fourth the luminance of the luminance corresponding to the first digital value.

In one embodiment, the first digital values and the second digital values are experimentally and previously stored in the LUT 172. In other words, the first digital values and the second digital values are previously stored in the LUT 172 through various experiments so that degradation of the organic light emitting diode OLED can be compensated corresponding to various third digital values supplied from the ADC2 171.

A seventh transistor M7 is located between the LUT 172 and the DAC 124m. The seventh transistor M7 is turned on during a second period of the sensing period. The buffer 125m is constructed using an operational amplifier 200. A polarity of input terminals of the operational amplifier 200 is inverted according to an external control signal.

An eighth transistor M8 is located between a first input terminal of the operational amplifier 200 and the DAC 124m. The eighth transistor M8 is turned on during the second period of the sensing period.

A ninth transistor M9 is located between a second input terminal of the operational amplifier 200 and the organic light emitting diode OLED. The ninth transistor M9 is turned on during the second period of the sensing period.

The second input terminal of the operational amplifier 200 is coupled with a first terminal of a tenth transistor M10, and an output terminal of the operational amplifier 200 is coupled with a second terminal of the tenth transistor M10. The tenth transistor M10 is turned off during the sensing period, but is turned on during a normal driving period.

A twelfth transistor M12 is located between the holding latch 123m and the DAC 124m. The twelfth transistor M12 is turned on during the normal driving period, but is turned off during the sensing period.

The timing controller 150 includes a memory 152 and a calculator 151. The memory 152 stores the fourth digital value and the fifth digital value supplied from the ADC1 180. The calculator 151 generates and provides a second data Data2 to the data driver 120 using the fourth digital value and the fifth digital value stored in the memory 152. Here, the second data Data2 is obtained by changing a bit value of the first data Data1.

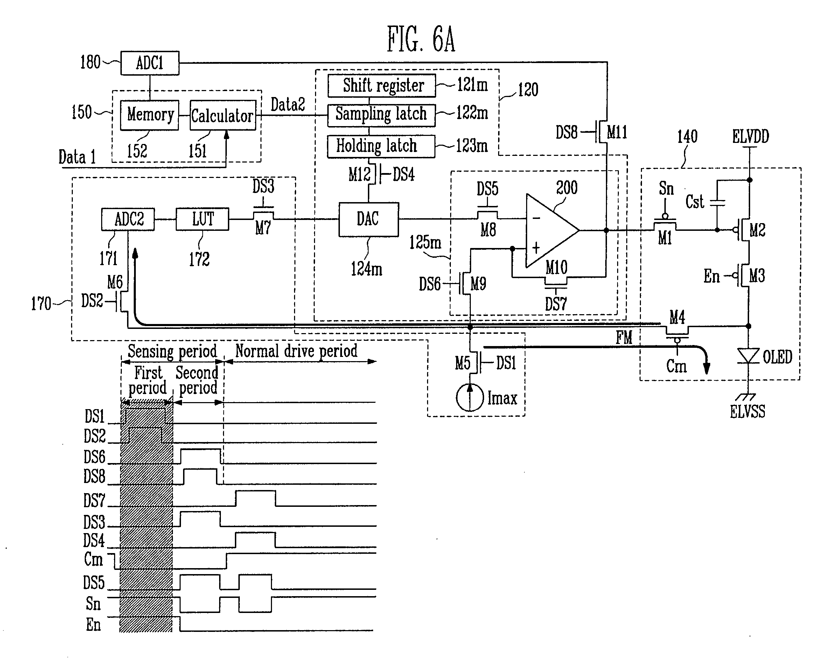

FIG. 6A through FIG. 6C are schematic diagrams for illustrating a method for driving an organic light emitting display in association with a drive waveform.

FIG. 6A through FIG. 6C, for the convenience of description, show the pixel 140 coupled to an n-th scan line Sn and an m-th data line Dm.

Referring to FIG. 6A, during the first period of the sensing period, a first drive signal DS1, a second drive signal DS2, an emission control signal, and a control signal (a low level signal) are supplied.

When the first drive signal DS1 is supplied, the fifth transistor M5 is turned on. When the second drive signal DS2 is supplied, the sixth transistor M6 is turned on. When an emission control signal is supplied to an n-th emission control line En, the third transistor M3 is turned off. When a control signal is supplied to a control line Cm, the fourth transistor M4 is turned on.

When the fifth transistor M5 and the fourth transistor M4 are turned on, an electric current from the current source Imax is supplied to a second power source ELVSS through the organic light emitting diode OLED. In this case, a voltage (e.g., a predetermined voltage) corresponding to the current of the current source Imax is applied to the organic light emitting diode OLED.

The voltage applied to the organic light emitting diode OLED is supplied to the ADC2 171 through the sixth transistor M6. The ADC2 171 converts the voltage applied to the organic light emitting diode OLED to a third digital value, and transfers the third digital value to the LUT 172.

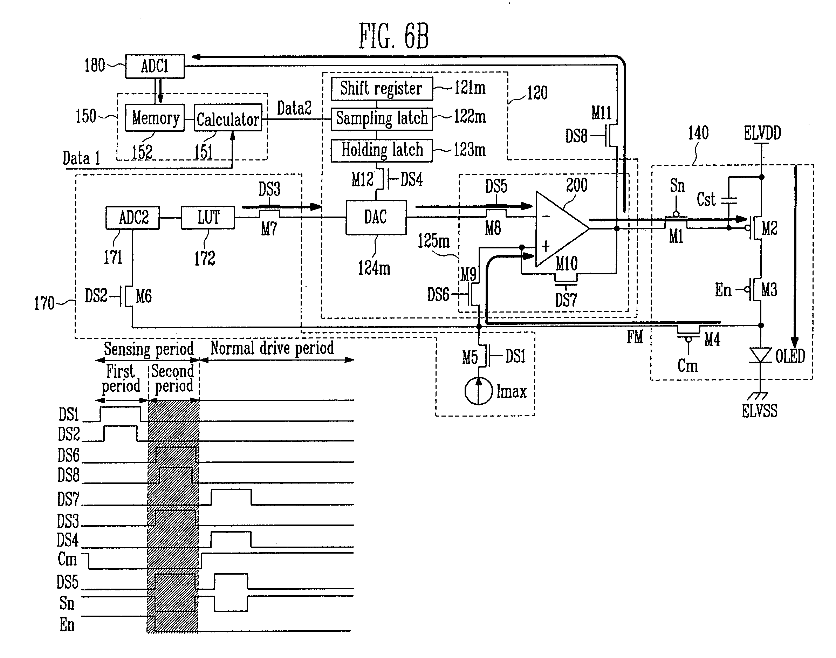

Next, as shown in FIG. 6B, during a second period of the sensing period, a third drive signal DS3, a fifth drive signal DS5, a sixth drive signal DS6, an eighth drive signal DS8, a scan signal (a low level signal), and a control signal (a low level signal) are supplied.

When the third drive signal DS3 is supplied, the seventh transistor M7 is turned on. When the fifth drive signal DS5 is supplied, the eighth transistor M8 is turned on. When the sixth drive signal DS6 is supplied, the ninth transistor M9 is turned on. When the eighth drive signal DS8 is supplied, an eleventh transistor M11 is turned on. When the scan signal is supplied, the first transistor M1 is turned on. When the control signal is supplied, the fourth transistor M4 is turned on.

When the seventh transistor M7 is turned on, the first digital value and the second digital value extracted from the LUT 172 corresponding to the third digital value are sequentially supplied to the DAC 124m at an interval (e.g., a predetermined interval). The DAC 124m converts the first digital value and the second digital value to analog voltages, and provides the analog voltages to the operational amplifier 200.

When a voltage supplied from the DAC 124m is provided to the first input terminal (-) of the operational amplifier 200, a voltage of the second input terminal (+) of the operational amplifier 200 is increased to become identical (or substantially identical) with a voltage of the first terminal (-). Accordingly, a voltage applied to a gate electrode of the second transistor M2 is set as the voltage of a second terminal (+) that is identical (or substantially identical) with the voltage of the first terminal (-). That is, a voltage capable of compensating for the degradation of the organic light emitting diode OLED is applied to a gate electrode of the second transistor M2. The ADC1 180 converts the voltage applied to the gate electrode of the second transistor M2 to a fourth digital value and a fifth digital value, and provide the fourth digital value and the fifth digital value to the memory 152.

Here, when a voltage corresponding to the first digital value is applied from the DAC 124m, the voltage applied to the gate electrode of the second transistor M2 can be expressed by the following Equation 1.

## Equation 1

$$Vdata\_\max = ELVDD - \sqrt{\frac{\alpha 2I_{max}}{\mu_{M2}Cox\frac{W}{L}}} - \left|V_{thM2}\right|$$

In the Equation 1, Vdata_max represents a voltage applied to a gate electrode of the second transistor M2 corresponding to the first digital value, and $\alpha$ represents a value to determine an increased amount of electric current corresponding to the degradation of the organic light emitting diode OLED. For example, when emission efficiency is reduced from 100 % to 75 % by the degradation of the organic light emitting diode OLED, the value $\alpha$ becomes 100/75. In the described embodiment, the value $\alpha$ is previously determined by the first digital value so the degradation of the organic light emitting diode OLED can be compensated. Further, in the Equation 1, $\mu$ represents mobility of the second transistor M2, Cox is a capacitance in an oxide layer of the second transistor M2, W is a channel width of the second transistor M2, L is a channel length of the second transistor M2, and $V_{th}$ represents a threshold voltage of the second transistor M2.
When a voltage corresponding to the second digital value is applied from the DAC 124m, the voltage applied to a gate electrode of the second transistor M2 may be expressed by a the following Equation 2.

## Equation 2

$$Vdata\_\min = ELVDD - \frac{1}{2}\sqrt{\frac{\alpha 2I_{max}}{\mu_{M2}Cox\frac{W}{L}}} - \left|V_{thM2}\right|$$

The applied voltage corresponding to the first digital value is converted to the fourth digital value, and the fourth digital value is stored in the memory 152. Further, the applied voltage corresponding to the second digital value is converted to a fifth digital value, and the fifth digital value is stored in the memory 152. During the sensing period, an operation shown in FIG. 6A and FIG. 6B repeats to convert degradation information of all the pixels 140 to the fourth digital value and the fifth digital value. The fourth and fifth digital values are stored in the memory 152. For example, after degradation information of a pixel 140 coupled with the first scan line S1 and the first data line D1 is sensed, degradation information of a pixel 140 coupled with the first scan line S1 and the second data line D2 may be sensed. In practice, during the sensing period, all the pixels 140 perform operations of the first and second periods as shown in FIG. 6A and FIG. 6B.

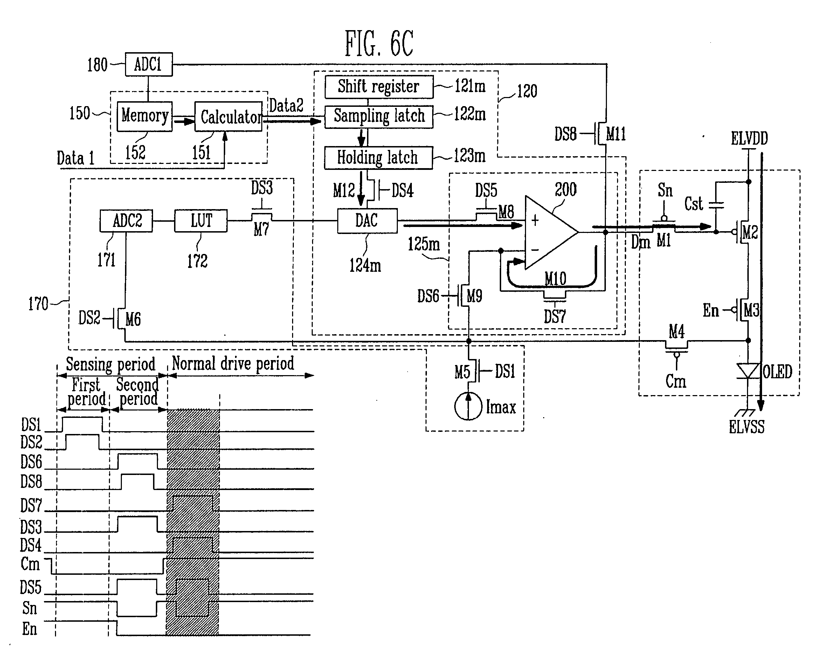

The sensing period takes place at a point in time where a power is supplied to the organic light emitting display. Accordingly, when the power is inputted to the organic light emitting display, degradation information of pixels 140 is stored in the memory 152. Next, during a normal driving period shown in FIG. 6C, the second data Data2 is generated using the degradation information stored in the memory 152.

During the normal driving period, the first data Data1 is supplied to the calculator 151. At this time, the calculator 151 generates a second data Data2 by changing a bit value of the first data Data1 using the fourth digital value and the fifth digital value from a specific pixel 140 to which the first data Data1 will be supplied.

The following is a generation procedure of the second data Data2 in more detail. Firstly, when the first data Data1 to be supplied to the specific pixel 140 is inputted, the fourth digital value and the fifth digital value corresponding to the specific pixel 140 are extracted from the memory 152.

Next, the calculator 151 subtracts the fourth digital value from the fifth digital value. When the fourth digital value is subtracted from the fifth digital value, information expressed by the following Equation 3 is obtained.

### Equation 3

$$Vdata\_\min - Vdata\_\max = \frac{1}{2}\sqrt{\frac{\alpha 2I_{\max}}{\mu_{M2}Cox\frac{W}{L}}}$$

As indicated in the Equation 3, when the fourth digital value is subtracted from the fifth digital value, mobility information and degradation information $\alpha$ to be compensated of the second transistor M2 remain.
Further, as indicated in the Equation 4 below, the calculator 151 multiplies the fifth digital value by two, subtracts the fourth digital value from the multiplying result, and subtracts the first power source ELVDD (value converted to a digital signal) from the subtraction result to obtain a threshold voltage of the second transistor M2.

### Equation 4

$$ELVDD - 2 \times Vdata\_\min - Vdata\_\max = \left| V_{thM2} \right|$$

Next, the calculator 151 multiplies the result of the Equation 3 by bit information (e.g., a number of bits) of the first data Data1 as indicated in the Equation 5 below, and adds the threshold voltage of the second transistor M2 to the multiplication result. Next, the calculator 151 subtracts a digital value of the first power source ELVDD from the addition result to generate the second data Data2.

### Equation 5

$$Data2 = ELVDD - \sqrt{4(\frac{x}{2^n - 1})\frac{1}{2}\sqrt{\frac{\alpha 2I_{\max}}{\mu_{M2}Cox\frac{W}{L}}}} - \left| V_{thM2} \right|$$

$$= ELVDD - \sqrt{(\frac{x}{2^n - 1})\frac{\alpha 2I_{\max}}{\mu_{M2}Cox\frac{W}{L}}} - \left| V_{thM2} \right|$$

In the Equation 5, n represents a number of bits of the first data Data1, x represents a gradation selected by the bits of the first data Data1. For example, when the first data Data1 has 8 bits and a value of 25 (i.e., the gray level of 25), n is set as 8 and x is selected as 25.

In the Equation 5, the second data Data2 includes bit information of the first data Data1, a threshold voltage and mobility information of the second transistor M2, and degradation information of the organic light emitting diode OLED. In other words, the second data Data2 is generated using the number of bits of Data1, the value of Data1, the threshold voltage and mobility information of the second transistor M2, and degradation information of the organic light emitting diode OLED.

The second data Data2 generated by the calculator 151 is stored in a sampling latch 122m. The second data Data2 stored in the sampling latch 122m is supplied to a holding latch 123m. Meanwhile, during the normal driving period shown in FIG. 6C, a fourth drive signal DS4, a fifth drive signal DS5, a seventh drive signal DS7, and the scan signal (a low level signal) are supplied.

When the fourth drive signal DS4 is supplied, the twelfth transistor M12 is turned on. When the fifth drive signal DS5 is supplied, the eighth transistor M8 is turned on. When the seventh drive signal DS7 is supplied, the tenth transistor M10 is turned on. Further, during the normal driving period corresponding to a control signal supplied to the operational amplifier 200, the first input terminal is set as a positive polarity terminal (+), and the second input terminal is set as a negative polarity terminal (-). At this time, because the tenth transistor M10 is set in a turned-on state, the operational amplifier 200 operates as a buffer.

Since the twelfth transistor M12 is set in a turned-on state, the second data Data2 is supplied to the DAC 124m. At this time, the DAC 124m converts the second data Data2 to a data signal (analog signal) and provides the data signal to the operational amplifier 200.

The data signal supplied to the operational amplifier 200 is provided and stored in a storage capacitor Cst of a pixel 140 selected by a scan signal supplied to the scan line Sn. Next, the second transistor M2 provides an electric current corresponding to a voltage stored in the storage capacitor Cst to the organic light emitting diode OLED.

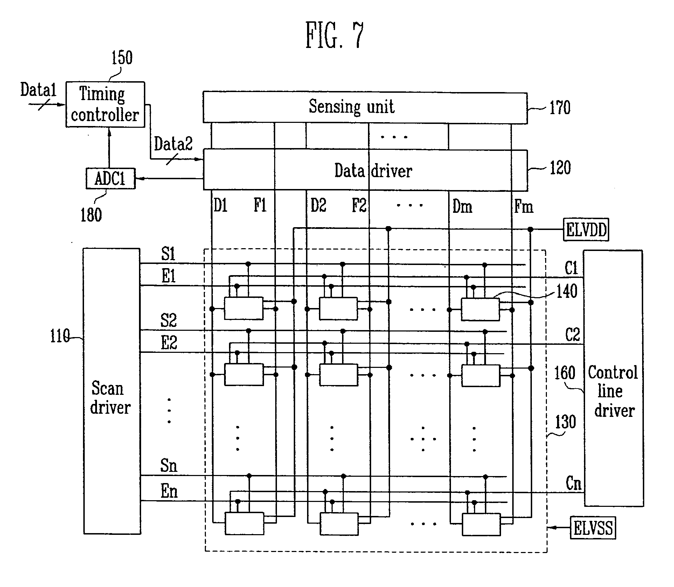

At this time, the voltage charged in the storage capacitor Cst is set as a voltage, which may compensate for degradation of the organic light emitting diode OLED, a threshold voltage and mobility of the second transistor M2. Accordingly, the organic light emitting diode OLED may generate light of desired luminance corresponding to an electric current supplied from the second transistor M2. Meanwhile, FIG. 2 shows control lines C1 through Cm formed in parallel with the data lines D1 through Dm. However, the present invention is not limited thereto. In other words, as shown in FIG. 7 for example, the control lines C1 through Cn may be formed in parallel with the scan lines S1 through Sn. In this case, during the sensing period, a control signal is sequentially supplied to the control lines C1 through Cn. Each time the control signal is supplied, the sixth transistor M6 located in each channel is sequentially turned on to sense degradation information of the organic light emitting diode OLED.

As is seen from the forgoing description, in the organic light emitting display and a method for driving the same, a voltage applied to a gate electrode of a drive transistor is converted to a fourth digital value and a fifth digital value corresponding to extracted information, and they are stored in a memory. Next, a bit value of data is changed using the fourth digital value and the fifth digital value stored in the memory to compensate for degradation of an organic light emitting diode, and a threshold voltage and mobility of a drive transistor. Accordingly, embodiments of the present invention may display images of desired luminance regardless of the degradation of the organic light emitting diode, and the threshold voltage and mobility of a drive transistor.

Although exemplary embodiments of the present invention have been shown and described, it would be appreciated by those skilled in the art that changes might be made in these embodiments without departing from the scope of the invention as defined in the claims.

## Claims

1. An organic light emitting display comprising:

   pixels (140) at crossing regions of data lines (D1...Dm), scan lines (S1...Sn), feedback lines (F1...Fn), control lines (C1...Cm), and emission control lines (E1...En), each of the pixels (140) comprising an organic light emitting diode, a drive transistor (M2) and an emission control transistor (M3) connected in series with the organic light emitting diode, wherein the emission control transistor (M3) is connected between the drive transistor (M2) and an anode of the organic light emitting diode and is controlled by a respective one of said emission control lines;
   a scan driver (110) configured to drive the scan lines and the emission control lines;
   a control line driver (160) configured to drive the control lines;
   a sensing unit (170) configured, in a first period, to supply an electric current to an organic light emitting diode of a pixel via the feedback line of the pixel and to extract degradation information of the organic light emitting diode by receiving via the feedback line a voltage of the anode of the organic light emitting diode, wherein the feedback line is connected to the anode of the organic light emitting diode via a switch (M4) configured to be switched on in the first period by a respective one of the control lines, and wherein the emission control transistor (M3) is arranged to be switched off in the first period, the sensing unit (170) being further configured to sequentially generate and output a first digital value and a second digital value according to the extracted degradation information of the organic light emitting diode respectively in first and second intervals of a second period, the sensing unit (170) being further arranged to covert the voltage of the anode of the organic light emitting diode to a third digital value and two provide the third digital value to a look-up table, the look-up table being arranged to output the first digital value and the second digital value according to the third digital value;
   a data driver (120) configured to receive and convert the first and second digital values into first and second voltages, wherein the first voltage is such that, if applied to an anode of the organic light emitting diode, it compensates for degradation of the organic light emitting diode in correspondence of a first predetermined luminance level, and the second voltage is such that, if applied to the anode of the organic light emitting diode it induces a second predetermined current in correspondence of a second predetermined luminance level, and to generate data signals corresponding to second data during a normal driving period;
   an operational amplifier (200) for each data line included in the data driver (120) comprising a first input terminal, a second input terminal, and an output terminal connected to the data line for the pixel, wherein the first input terminal is arranged to receive the first voltage in the first interval and the second voltage in the second interval, wherein the second input terminal is connected to the feedback line of the pixel and is arranged to receive the output of the feedback line of the pixel in the second period, wherein the switch (M4) is controlled to be switched on in the second period, and the emission control transistor (M3) is controlled to be switched on in the second period, and wherein the output terminal is connected to a gate electrode of the drive transistor of the pixel;

a first analog-digital converter (180) configured to receive and convert the voltage applied to the gate electrode of the drive transistor in the first interval into a fourth digital value, and to receive and convert the voltage applied to the gate electrode of the drive transistor in the second interval into a fifth digital value; and

a timing controller (150) configured to store the fourth digital value and the fifth digital value, and to change externally supplied first data in accordance with the fourth digital value and the fifth digital value to generate the second data to compensate for degradation of the organic light emitting diode, and a mobility and a threshold voltage of the drive transistor.

2.  The organic light emitting display as claimed in claim 1, wherein the data driver (120) comprises:

a shift register unit (121) comprising a plurality of shift registers (1211, 1212...121m) configured to sequentially generate sampling signals;

a sampling latch unit (122) comprising a plurality of sampling latches (1221, 1222...122m) configured to sequentially store the second data corresponding to the sampling signals;

a holding latch unit (123) comprising a plurality of holding latches (1231, 1232...123m) configured to temporarily store the second data stored in the sampling latch unit (122);

a signal generator (124) comprising a plurality of digital-analog converters (1241, 1242...124m) configured to generate the data signal utilizing the second data stored in the holding latch unit (123); and

a buffer unit (125) comprising a plurality of buffers (1251, 1252...125m) configured to transfer the data signal to the data lines.

3.  The organic light emitting display as claimed in claim 2, wherein the sensing unit (170) comprises:

a plurality of current sources (Imax) coupled to the feedback lines (F1, F2...Fm) for supplying the electric current;

a second analog-digital converter (171) coupled to the feedback lines and configured to convert the voltage applied to anode of the organic light emitting diode of the pixel to the third digital value when the electric current is supplied to a digital-analog converter (124m) connected between the look-up table and the first terminal of the operational amplifier (200).

4.  The organic light emitting display as claimed in claim 3, wherein a current value of each of the current source is between approximately 50 nA and approximately 50 μA.

5.  The organic light emitting display as claimed in claim 3, wherein the first and second voltages are different.

6.  The organic light emitting display as claimed in claim 5, wherein the first voltage is a voltage to be applied to the anode electrode of the organic light emitting diode to express luminance of a maximum gradation regardless of the degradation information of the organic light emitting diode.

7.  The organic light emitting display as claimed in claim 6, wherein the second voltage is a voltage to be applied to the anode electrode of the organic light emitting diode for generating one fourth luminance of a maximum gradation or for generating luminance of a minimum gradation by the organic light emitting diode.

8.  The organic light emitting display as claimed in claim 3, wherein the sensing unit (170) comprises:

a transistor (M5) between each of the current sources and each of the feedback lines, and being turned on during the first period of the sensing period;

a transistor (M6) between the second analog-digital converter (171) and each of the feedback lines, and being turned on during the first period of the sensing period; and

a transistor (M7) between the look-up table (172) and the digital-analog converter (124m), and being turned on during the second period of the sensing period.

9.  The organic light emitting display as claimed in claim 3, further comprising:

an transistor (M8) between the first input terminal of the operational amplifier (200) and the digital-analog converter (124m), and turned on during the second period of the sensing period;

a transistor (M9) between the second input terminal of the operational amplifier (200) and a corresponding feedback line among the feedback lines, and turned on during the second period of the sensing period; and

a transistor (M10) between the second input terminal and an output terminal of the operational amplifier (200), and being turned on during the normal driving period.

10. The organic light emitting display as claimed in claim 9, wherein the timing controller (150) comprises:

a memory (152) for storing the fourth digital value and the fifth digital value; and

a calculator (151) for changing the externally supplied first data in accordance with the fourth and fifth digital values to generate the second data.

11. The organic light emitting display as claimed in claim 10, wherein the fourth and fifth digital values of all of the plurality of pixels are stored in the memory, wherein the calculator is configured to extract the fourth digital value and the fifth digital value corresponding to the pixel from the memory (152) when the first data to be supplied to the pixel is inputted, and changes the first data to generate the second data so that a degradation of the organic light emitting diode of the pixel, and a threshold voltage and mobility of the drive transistor in the pixel are compensated.

12. A method of driving the organic light emitting display as defined in claim 1, the method comprising:

using the scan driver (110) to drive the scan lines and the emission control lines;

using the control line driver (160) to drive the control lines;

using the sensing unit (170) to, in a first period, supply an electric current to an organic light emitting diode of a pixel via the feedback line of the pixel and to extract degradation information of the organic light emitting diode by receiving via the feedback line a voltage of the anode of the organic light emitting diode, wherein the feedback line is connected to the anode of the organic light emitting diode via a switch (M4) configured to be switched on in the first period by a respective one of the control lines, the sensing unit (170) being further configured to sequentially generate and output a first digital value and a second digital value according to the extracted degradation information of the organic light emitting diode respectively in first and second intervals of a second period, the sensing unit (170) coverting the voltage of the anode of the organic light emitting diode to a third digital value and providing the third digital value to a look-up table, the look-up table outputting the first digital value and the second digital value according to the third digital value;

using the data driver (120) to receive and convert the first and second digital values into first and second voltages, wherein the first voltage is such that, if applied to an anode of the organic light emitting diode, it compensates for degradation of the organic light emitting diode in correspondence of a first predetermined luminance level, and the second voltage is such that, if applied to the anode of the organic light emitting diode it induces a second predetermined current in correspondence of a second predetermined luminance level, and to generate data signals corresponding to second data during a normal driving period;

using the operational amplifier (200) for each data line comprising a first input terminal, a second input terminal, and an output terminal connected to the data line for the pixel, the operational amplifier (200) receiving at the first input terminal the first voltage in the first interval and the second voltage in the second interval, wherein the second input terminal is connected to the feedback line of the pixel and the operational amplifier (200) receiving the output of the feedback line of the pixel in the second period, wherein the switch (M4) is controlled to be switched on in the second period, and the emission control transistor (M3) is controlled to be switched off in the first period and switched on in the second period, and wherein the output terminal is connected to a gate electrode of the drive transistor of the pixel;

using the first analog-digital converter (180) to receive and convert the voltage applied to the gate electrode of the drive transistor in the first interval into a fourth digital value, and to receive and convert the voltage applied to the gate electrode of the drive transistor in the second interval into to a fifth digital value; and

using the timing controller (150) to store the fourth digital value and the fifth digital value, and to change externally supplied first data in accordance with the fourth digital value and the fifth digital value to generate the second data to compensate for degradation of the organic light emitting diode, and a mobility and a threshold voltage of the drive transistor.

13. The method as claimed in claim 12, wherein a current value of the current source is between approximately 50 nA and approximately 50 μ4.

14. The method as claimed in claim 12 or 13, wherein the first voltage is a voltage to be applied to the anode electrode of the organic light emitting diode to express luminance of a maximum gradation regardless of the degradation information of the organic light emitting diode.

15. The method as claimed in claim 14, wherein the second voltage is a voltage to be applied to the anode electrode of the organic light emitting diode for generating one fourth luminance of a maximum gradation or for generating luminance of a minimum gradation by the organic light emitting diode.

**Patentansprüche**

1. Organische lichtemittierende Anzeige, umfassend:

Pixel (140) an Kreuzungsbereichen von Datenleitungen (D1...Dm), Abtastzeilen (S1...Sn), Rückführungsleitungen (F1...Fn), Steuerleitungen (C1...Cm) sowie Emissionssteuerleitungen (E1...En), wobei jedes der Pixel (140) eine organische lichtemittierende Diode, einen Treibertransistor (M2) sowie einen mit der organischen lichtemittierenden Diode in Serie geschalteten Emissionssteuertransistor (M3) umfasst, wobei der Emissionssteuertransistor (M3) zwischen den Treibertransistor (M2) und eine Anode der organischen lichtemittierenden Diode geschaltet ist und von einer entsprechenden der Emissionssteuerleitungen gesteuert wird, einen Abtasttreiber (110), der zum Ansteuern der Abtastzeilen und der Emissionssteuerleitungen ausgelegt ist; ein Steuerleitungstreiber (160), der zum Ansteuern der Steuerleitungen ausgelegt ist; eine Sensoreinheit (170), die dazu ausgelegt ist, in einer ersten Periode einer organischen lichtemittierenden Diode eines Pixels über die Rückführungsleitung des Pixels einen elektrischen Strom zuzuführen und durch das Erhalten einer Spannung der Anode der organischen lichtemittierenden Diode über die Rückführungsleitung Verschlechterungsinformationen der organischen lichtemittierenden Diode zu extrahieren, wobei die Rückführungsleitung mit der Anode der organischen lichtemittierenden Diode über einen Schalter (M4) verbunden ist, der so ausgelegt ist, dass er in der ersten Periode durch eine entsprechende der Steuerleitungen eingeschaltet wird, und wobei der Emissionssteuertransistor (M3) so eingerichtet ist, dass er in der ersten Periode ausgeschaltet wird, wobei die Sensoreinheit (170) ferner dazu ausgelegt ist, einen ersten Digitalwert und einen zweiten Digitalwert gemäß der extrahierten Verschlechterungsinformationen der organischen lichtemittierenden Diode jeweils in ersten und zweiten Intervallen einer zweiten Periode sequentiell zu erzeugen und auszugeben, wobei die Sensoreinheit (170) ferner eingerichtet ist, die Spannung der Anode der organischen lichtemittierenden Diode in einen dritten Digitalwert umzuwandeln und den dritten Digitalwert einer Verweistabelle bereitzustellen, wobei die Verweistabelle eingerichtet ist, den ersten Digitalwert und den zweiten Digitalwert gemäß dem dritten Digitalwert auszugeben; einen Datentreiber (120), der dazu ausgelegt ist, die ersten und zweiten Digitalwerte zu empfangen und in erste und zweite Spannungen umzuwandeln, wobei die erste Spannung derart ist, dass sie bei Anlegen an eine Anode der organischen lichtemittierenden Diode eine Verschlechterung der organischen lichtemittierenden Diode entsprechend einem ersten vorbestimmten Luminanzpegel kompensiert, und die zweite Spannung derart ist, dass sie bei Anlegen an die Anode der organischen lichtemittierenden Diode einen zweiten vorbestimmten Strom entsprechend einem zweiten vorbestimmten Luminanzpegel induziert, und Datensignale entsprechend zweiter Daten während einer normalen Ansteuerungsperiode zu erzeugen; einen Operationsverstärker (200) für jede in dem Datentreiber (120) enthaltene Datenleitung, umfassend einen ersten Eingangsanschluss, einen zweiten Eingangsanschluss sowie einen mit der Datenleitung für das Pixel verbundenen Ausgangsanschluss, wobei der erste Eingangsanschluss eingerichtet ist, die erste Spannung im ersten Intervall und die zweite Spannung im zweiten Intervall zu erhalten, wobei der zweite Eingangsanschluss mit der Rückführungsleitung des Pixels verbunden und eingerichtet ist, den Ausgang der Rückführungsleitung des Pixels in der zweiten Periode zu empfangen, wobei der Schalter (M4) so gesteuert ist, dass er in der zweiten Periode eingeschaltet wird, und der Emissionssteuertransistor (M3) so gesteuert ist, dass er in der zweiten Periode eingeschaltet wird, und wobei der Ausgangsanschluss mit einer Gate-Elektrode des Treibertransistors des Pixels verbunden ist; einen ersten Analog-Digital-Wandler (180), der dazu ausgelegt ist, die im ersten Intervall an die Gate-Elektrode des Treibertransistors angelegte Spannung zu erhalten und in einen vierten Digitalwert umzuwandeln, und die im zweiten Intervall an die Gate-Elektrode des Treibertransistors angelegte Spannung zu erhalten und in einen fünften Digitalwert umzuwandeln; und eine Zeitsteuerung (150), die dazu ausgelegt ist, den vierten Digitalwert und den fünften Digitalwert zu speichern sowie extern zugeführte erste Daten gemäß dem vierten Digitalwert und dem fünften Digitalwert zu verändern, um die zweiten Daten zur Kompensation einer Verschlechterung der organische lichtemittierenden Diode und einer Mobilität und einer Schwellenspannung des Treibertransistors zu erzeugen.

**2.** Organische lichtemittierende Anzeige nach Anspruch 1, wobei der Datentreiber (120) umfasst:

eine Schieberegistereinheit (121) umfassend eine Vielzahl von Schieregistern (1211, 1212...121 m), die dazu ausgelegt ist, sequentiell Abtastsignale zu erzeugen; eine Abtast-Latch-Einheit (122) umfassend eine Vielzahl von Abtast-Latches (1221, 1222...122m), die dazu ausgelegt sind, die zweiten Daten entsprechend der Abtastsignale sequentiell zu speichern;

eine Halte-Latch-Einheit (123) umfassend eine Vielzahl von Halte-Latches (1231, 1232...123m), die dazu ausgelegt ist, die in der Abtast-Latch-Einheit (122) gespeicherten zweiten Daten temporär zu speichern;

einen Signalgeber (124) umfassend eine Vielzahl von Digital-Analog-Wandlern (1241, 1242...124m), der dazu ausgelegt ist, das Datensignal unter Verwendung der in der Halte-Latch-Einheit (123) gespeicherten zweiten Daten zu erzeugen; und

eine Puffereinheit (125) umfassend eine Vielzahl von Puffern (1251, 1252...125m), die dazu ausgelegt ist, das Datensignal an die Datenleitungen zu übertragen.

**3.** Organische lichtemittierende Anzeige nach Anspruch 2, wobei die Sensoreinheit (170) umfasst:

eine mit den Rückführungsleitungen (F1, F2...Fm) verbundene Vielzahl von Stromquellen (Imax) zum Zuführen des elektrischen Stroms;

einen zweiten Analog-Digital-Wandler (171), der mit den Rückführungsleitungen verbunden und dazu ausgelegt ist, die an die Anode der organischen lichtemittierenden Diode des Pixels angelegte Spannung in den dritten Digitalwert umzuwandeln, wenn der elektrische Strom einem zwischen die Verweistabelle und den ersten Anschluss des Operationsverstärkers (200) geschalteten Digital-Analog-Wandler (124m) zugeführt wird.

**4.** Organische lichtemittierende Anzeige nach Anspruch 3, wobei ein Stromwert jeder der Stromquellen zwischen ca. 50 nA und ca. 50 μA liegt.

**5.** Organische lichtemittierende Anzeige nach Anspruch 3, wobei die ersten und zweiten Spannungen unterschiedlich sind.

**6.** Organische lichtemittierende Anzeige nach Anspruch 5, wobei die erste Spannung eine an die Anodenelektrode der organischen lichtemittierenden Diode anzulegende Spannung ist, um die Luminanz einer maximalen Gradation ungeachtet der Verschlechterungsinformationen der organischen lichtemittierenden Diode auszudrücken.

**7.** Organische lichtemittierende Anzeige nach Anspruch 6, wobei die zweite Spannung eine an die Anodenelektrode der organischen lichtemittierenden Diode anzulegende Spannung ist, um eine vierte Luminanz einer maximalen Gradation zu erzeugen oder um eine Luminanz einer minimalen Gradation durch die organische lichtemittierende Diode zu erzeugen.

**8.** Organische lichtemittierende Anzeige nach Anspruch 3, wobei die Sensoreinheit (170) umfasst:

einen Transistor (M5) zwischen jeder der Stromquellen und jeder der Rückführungsleitungen, der während der ersten Periode der Erfassungsperiode eingeschaltet ist;

einen Transistor (M6) zwischen dem zweiten Analog-Digital-Wandler (171) und jeder der Rückführungsleitungen, der während der ersten Periode der Erfassungsperiode eingeschaltet ist; und

einen Transistor (M7) zwischen der Verweistabelle (172) und dem Digital-Analog-Wandler (124m), der während der zweiten Periode der Erfassungsperiode eingeschaltet ist.

**9.** Organische lichtemittierende Anzeige nach Anspruch 3, ferner umfassend:

einen Transistor (M8) zwischen dem ersten Eingangsanschluss des Operationsverstärkers (200) und dem Digital-Analog-Wandler (124m), der während der zweiten Periode der Erfassungsperiode eingeschaltet ist;

einen Transistor (M9) zwischen dem zweiten Eingangsanschluss des Operationsverstärkers (200) und einer entsprechenden Rückführungsleitung unter den Rückführungsleitungen, der während der zweiten Periode der Erfassungsperiode eingeschaltet ist; und

einen Transistor (M10) zwischen dem zweiten Eingangsanschluss und einem Ausgangsanschluss des Operationsverstärkers (200), der während der normalen Ansteuerungsperiode eingeschaltet ist.

**10.** Organische lichtemittierende Anzeige nach Anspruch 9, wobei die Zeitsteuerung (150) umfasst:

einen Speicher (152) zum Speichern des vierten Digitalwerts und des fünften Digitalwerts; und
einen Rechner (151) zum Verändern der extern zugeführten ersten Daten gemäß den vierten und fünften Digitalwerten zur Erzeugung der zweiten Daten.

**11.** Organische lichtemittierende Anzeige nach Anspruch 10, wobei die vierten und fünften Digitalwerte sämtlicher der Vielzahl von Pixeln in dem Speicher gespeichert sind, wobei der Rechner dazu ausgelegt ist, den vierten Digitalwert und den fünften Digitalwert entsprechend dem Pixel aus dem Speicher (152) zu extrahieren, wenn die ersten dem Pixel zuzuführenden Daten eingegeben werden, und die ersten Daten zur Erzeugung der zweiten Daten ändert, so dass eine Verschlechterung der organischen lichtemittierenden Diode des Pixels sowie eine Schwellenspannung und Mobilität des Treibertransistors in dem Pixel kompensiert werden.

**12.** Verfahren zum Ansteuern der organischen lichtemittierenden Anzeige nach Anspruch 1, wobei das Verfahren umfasst:

Verwenden des Abtasttreibers (110) zum Ansteuern der Abtastzeilen und der Emissionssteuerleitungen;
Verwenden des Steuerleitungstreibers (160) zum Ansteuern der Steuerleitungen;
Verwenden der Sensoreinheit (170) zum Zuführen eines elektrischen Stroms an eine organische lichtemittierende Diode eines Pixels über die Rückführungsleitung des Pixels in einer ersten Periode und zum Extrahieren von Verschlechterungsinformationen der organischen lichtemittierenden Diode durch das Erhalten einer Spannung der Anode der organischen lichtemittierenden Diode über die Rückführungsleitung, wobei die Rückführungsleitung mit der Anode der organischen lichtemittierenden Diode über einen Schalter (M4) verbunden ist, der so ausgelegt ist, dass er in der ersten Periode durch eine entsprechende der Steuerleitungen eingeschaltet wird, wobei die Sensoreinheit (170) ferner dazu ausgelegt ist, einen ersten Digitalwert und einen zweiten Digitalwert gemäß der extrahierten Verschlechterungsinformationen der organischen lichtemittierenden Diode jeweils in ersten und zweiten Intervallen einer zweiten Periode sequentiell zu erzeugen und auszugeben, wobei die Sensoreinheit (170) die Spannung der Anode der organischen lichtemittierenden Diode in einen dritten Digitalwert umwandelt und den dritten Digitalwert einer Verweistabelle bereitstellt, wobei die Verweistabelle den ersten Digitalwert und den zweiten Digitalwert gemäß dem dritten Digitalwert ausgibt;
Verwenden des Datentreibers (120) zum Empfangen und Umwandeln der ersten und zweiten Digitalwerte in erste und zweite Spannungen, wobei die erste Spannung derart ist, dass sie bei Anlegen an eine Anode der organischen lichtemittierenden Diode eine Verschlechterung der organischen lichtemittierenden Diode entsprechend einem ersten vorbestimmten Luminanzpegel kompensiert, und die zweite Spannung derart ist, dass sie bei Anlegen an die Anode der organischen lichtemittierenden Diode einen zweiten vorbestimmten Strom entsprechend einem zweiten vorbestimmten Luminanzpegel induziert, und zum Erzeugen von Datensignalen entsprechend zweiter Daten während einer normalen Ansteuerungsperiode;
Verwenden des Operationsverstärkers (200) für jede Datenleitung, umfassend einen ersten Eingangsanschluss, einen zweiten Eingangsanschluss sowie einen mit der Datenleitung für das Pixel verbundenen Ausgangsanschluss, wobei der Operationsverstärker (200) am ersten Eingangsanschluss die erste Spannung im ersten Intervall und die zweite Spannung im zweiten Intervall erhält, wobei der zweite Eingangsanschluss mit der Rückführungsleitung des Pixels verbunden ist und der Operationsverstärker (200) den Ausgang der Rückführungsleitung des Pixels in der zweiten Periode empfängt, wobei der Schalter (M4) so gesteuert ist, dass er in der zweiten Periode eingeschaltet wird, und der Emissionssteuertransistor (M3) so gesteuert ist, dass er in der ersten Periode ausgeschaltet und in der zweiten Periode eingeschaltet wird, und wobei der Ausgangsanschluss mit einer Gate-Elektrode des Treibertransistors des Pixels verbunden ist;
Verwenden des ersten Analog-Digital-Wandlers (180) zum Erhalten der im ersten Intervall an die Gate-Elektrode des Treibertransistors angelegten Spannung und Umwandeln in einen vierten Digitalwert, und zum Erhalten der im zweiten Intervall an die Gate-Elektrode des Treibertransistors angelegten Spannung und Umwandeln in einen fünften Digitalwert; und
Verwenden der Zeitsteuerung (150) zum Speichern des vierten Digitalwerts und des fünften Digitalwerts sowie zum Verändern extern zugeführter erster Daten gemäß dem vierten Digitalwert und dem fünften Digitalwert, um die zweiten Daten zur Kompensation einer Verschlechterung der organischen lichtemittierenden Diode und einer Mobilität und einer Schwellenspannung des Treibertransistors zu erzeugen.

**13.** Verfahren nach Anspruch 12, wobei ein Stromwert jeder Stromquelle zwischen ca. 50 nA und ca. 50 $\mu$A liegt.

**14.** Verfahren nach Anspruch 12 oder 13, wobei die erste Spannung eine an die Anodenelektrode der organischen lichtemittierenden Diode anzulegende Spannung ist, um die Luminanz einer maximalen Gradation ungeachtet der Verschlechterungsinformationen der organischen lichtemittierenden Diode auszudrücken.

**15.** Verfahren nach Anspruch 14, wobei die zweite Spannung eine an die Anodenelektrode der organischen lichtemittierenden Diode anzulegende Spannung ist, um eine vierte Luminanz einer maximalen Gradation zu erzeugen oder um eine Luminanz einer minimalen Gradation durch die organische lichtemittierende Diode zu erzeugen.

**Revendications**

**1.** Afficheur electroluminescent organique comprenant :

des pixels (140) dans des régions d'intersection de lignes de données (D1...Dm), de lignes de balayage (S1...Sn), de lignes de rétroaction (F1...Fn), de lignes de commande (C1...Cm), et de lignes de commande d'émission (E1...En), chacun des pixels (140) comprenant une diode électroluminescente organique, un transistor d'attaque (M2) et un transistor de commande d'émission (M3) connectés en série avec la diode électroluminescente organique, le transistor de commande d'émission (M3) étant connecté entre le transistor d'attaque (M2) et une anode de la diode électroluminescente organique et étant commandé par l'une respective desdites lignes de commande d'émission ;

un circuit d'attaque de balayage (110) configuré pour attaquer les lignes de balayage et les lignes de commande d'émission ;

un circuit d'attaque de ligne de commande (160) configuré pour attaquer les lignes de commande ;

une unité de détection (170) configurée, lors d'une première période, pour délivrer un courant électrique à une diode électroluminescente d'un pixel via la ligne de rétroaction du pixel et pour extraire des informations de dégradation de la diode électroluminescente organique par réception, via la ligne de rétroaction, d'une tension de l'anode de la diode électroluminescente organique, la ligne de rétroaction étant connectée à l'anode de la diode électroluminescente organique via un commutateur (M4) configuré pour être commuté à l'état passant lors de la première période par l'une, respective, des lignes de commande, et le transistor de commande d'émission (M3) étant conçu pour être commuté à l'état non passant lors de la première période, l'unité de détection (170) étant en outre configurée pour séquentiellement générer et fournir en sortie une première valeur numérique et une deuxième valeur numérique conformément aux informations de dégradation extraites de la diode électroluminescente organique, respectivement lors de premier et deuxième intervalles d'une deuxième période, l'unité de détection (170) étant en outre conçue pour convertir la tension de l'anode de la diode électroluminescente organique en une troisième valeur numérique et pour fournir la troisième valeur numérique à une table de consultation, la table de consultation étant conçue pour fournir en sortie la première valeur numérique et la deuxième valeur numérique en fonction de la troisième valeur numérique ;

un circuit d'attaque de données (120) configuré pour recevoir et convertir les première et deuxième valeurs numériques en des première et deuxième tensions, dans lequel la première tension est telle que, si elle est appliquée à une anode de la diode électroluminescente organique, elle compense la dégradation de la diode électroluminescente organique en correspondance avec un premier niveau de luminescence prédéterminé, et la deuxième tension est telle que, si elle est appliquée à l'anode de la diode électroluminescente organique, elle induise un deuxième courant prédéterminé en correspondance avec un deuxième niveau de luminance prédéterminé, et pour générer des signaux correspondant à des deuxièmes données pendant une période d'attaque normale ;

un amplificateur opérationnel (200) pour chaque ligne de données contenue dans le circuit d'attaque de données (120) comprenant une première borne d'entrée, une deuxième borne d'entrée et une borne de sortie connectée à la ligne de données destinée au pixel, dans lequel la première borne d'entrée est conçue pour recevoir la première tension lors du premier intervalle et la deuxième tension lors du deuxième intervalle, dans lequel la deuxième borne d'entrée est connectée à la ligne de rétroaction du pixel et est conçue pour recevoir la sortie de la ligne de rétroaction du pixel lors de la deuxième période, le commutateur (M4) étant commandé de manière à être commuté à l'état passant lors de la deuxième période, et le transistor de commande d'émission (M3) étant commandé pour être commuté à l'état passant lors de la deuxième période, et dans lequel la borne de sortie est connectée à une électrode de grille du transistor d'attaque du pixel ;

un premier convertisseur analogique-numérique (180) configuré pour recevoir et convertir la tension appliquée à l'électrode de grille du transistor d'attaque lors du premier intervalle en une quatrième valeur numérique, et pour recevoir et convertir la tension appliquée à l'électrode de grille du transistor d'attaque lors du deuxième intervalle en une cinquième valeur numérique ; et

une unité de commande de cadencement (150) configurée pour stocker la quatrième valeur numérique et la cinquième valeur numérique, et pour modifier des premières données fournies de l'extérieur en fonction de la quatrième valeur numérique et la cinquième valeur numérique afin de générer les deuxièmes données pour compenser la dégradation de la diode électroluminescente organique, et une mobilité et une tension de seuil du transistor d'attaque.

2. Afficheur électroluminescent organique selon la revendication 1, dans lequel le circuit d'attaque de données (120) comprend :

une unité à registres à décalage (121) comprenant une pluralité de registres à décalage (1211, 1212...121m) configurée pour générer séquentiellement des signaux d'échantillonnage ;
une unité de verrouillage-échantillonnage (122) comprenant une pluralité de bascules (1221, 1222...122m) configurée pour générer séquentiellement des deuxièmes données correspondant aux signaux d'échantillonnage ;
une unité de verrouillage-maintien (123) comprenant une pluralité de bascules de maintien (1231, 1232...123m) configurée pour stocker temporairement les deuxièmes données stockées dans l'unité de verrouillage-échantillonnage (122) ;
un générateur de signal (124) comprenant une pluralité de convertisseurs numérique-analogique (1241, 1242... 124m) configuré pour générer le signal de données en utilisant les deuxièmes données stockées dans l'unité de verrouillage-maintien (123) ; et
une unité tampon (125) comprenant une pluralité de tampons (1251, 1252...125m) configurée pour transférer le signal de données aux lignes de données.

3. Afficheur électroluminescent organique selon la revendication 2, dans lequel l'unité de détection (170) comprend :

une pluralité de sources de courant (Imax) reliées aux lignes de rétroaction (F1, F2...Fm) pour délivrer le courant électrique ;
un deuxième convertisseur analogique-numérique (171) relié aux lignes de rétroaction et configuré pour convertir la tension appliquée à l'anode de la diode électroluminescente organique du pixel en la troisième valeur numérique lorsque le courant électrique est délivré à un convertisseur numérique-analogique (124n) connecté entre la table de consultation et la première borne de l'amplificateur opérationnel (200).

4. Afficheur électroluminescent organique selon la revendication 3, dans lequel une valeur de courant de chacune des sources de courant est comprise entre environ 50 nA et environ 50 $\mu$A.

5. Afficheur électroluminescent organique selon la revendication 3, dans lequel les première et deuxième tensions sont différentes.

6. Afficheur électroluminescent organique selon la revendication 5, dans lequel la première tension est une tension devant être appliquée à l'électrode d'anode de la diode électroluminescente organique pour exprimer une luminance d'une gradation maximale indépendamment des informations de dégradation de la diode électroluminescente organique.

7. Afficheur électroluminescent organique selon la revendication 6, dans lequel la deuxième tension est une tension devant être appliquée à l'électrode d'anode de la diode électroluminescente organique pour générer une quatrième luminance d'une gradation maximale ou pour générer une luminance d'une gradation minimale au moyen de la diode électroluminescente organique.

8. Afficheur électroluminescent organique selon la revendication 3, dans lequel l'unité de détection (170) comprend :

un transistor (M5) entre chacune des sources de courant et chacune des lignes de rétroaction, et qui est rendu passant pendant la première période de la période de détection ;
un transistor (M6) entre le deuxième convertisseur analogique-numérique (171) et chacune des lignes de rétroaction, et qui est rendu passant pendant la première période de la période de détection ; et
un transistor (M7) entre la table de consultation (172) et le convertisseur analogique-numérique (124m), et qui est rendu passant pendant la deuxième période de la période de détection.

9. Afficheur électroluminescent organique selon la revendication 3, comprenant en outre :

un transistor (M8) entre la première borne d'entrée de l'amplificateur opérationnel (200) et le convertisseur numérique-analogique (124m), et qui est rendu passant pendant la deuxième période de la période de détection ;
un transistor (M9) entre la deuxième borne d'entrée de l'amplificateur opérationnel (200) et une ligne de rétroaction correspondante parmi les lignes de rétroaction, et qui est rendu passant pendant la deuxième période de la période de détection ; et

un transistor (M10) entre la deuxième borne d'entrée et une borne de sortie de l'amplificateur opérationnel (200), et qui est rendu passant pendant la période d'attaque normale.

**10.** Afficheur électroluminescent organique selon la revendication 9, dans lequel l'unité de commande de cadencement (150) comprend :

une mémoire (152) destinée à stocker la quatrième valeur numérique et la cinquième valeur numérique ; et un calculateur (151) destiné à modifier les premières données délivrées de l'extérieur conformément aux quatrième et cinquième valeurs numériques afin de générer les deuxièmes données.

**11.** Afficheur électroluminescent organique selon la revendication 10, dans lequel les quatrième et cinquième valeurs numériques de la totalité de la pluralité de pixels sont stockées dans la mémoire, dans lequel le calculateur est configuré pour extraire la quatrième valeur numérique et la cinquième valeur numérique correspondant au pixel à partir de la mémoire (152) lorsque les premières données devant être fournies au pixel sont fournies en entrée, et modifie les premières données afin de générer les deuxièmes données de façon à compenser une dégradation de la diode électroluminescente organique du pixel, et une tension de seuil et la mobilité du transistor d'attaque dans le pixel.

**12.** Procédé d'attaque d'afficheur électroluminescent organique selon la revendication 1, le procédé consistant à :

utiliser le circuit d'attaque de balayage (110) pour attaquer les lignes de balayage et les lignes de commande d'émission ;

utiliser le circuit d'attaque de ligne de commande (160) pour attaquer les lignes de commande ;

utiliser l'unité de détection (170) pour, lors d'une première période, délivrer un courant électrique à une diode électroluminescente organique d'un pixel via la ligne de rétroaction du pixel et pour extraire des informations de dégradation de la diode électroluminescente organique par réception, via la ligne de rétroaction, d'une tension de l'anode de la diode électroluminescente organique, la ligne de rétroaction étant connectée à l'anode de la diode électroluminescente organique via un commutateur (M4) configuré pour être commuté à l'état passant lors de la première période par l'une, respective, des lignes de commande, l'unité de détection (170) étant en outre configurée pour séquentiellement générer et fournir en sortie une première valeur numérique et une deuxième valeur numérique conformément aux informations de dégradation extraites de la diode électroluminescente organique, respectivement lors de premier et deuxième intervalles d'une deuxième période, l'unité de détection (170) convertissant la tension de l'anode de la diode électroluminescente organique en une troisième valeur numérique et fournissant la troisième valeur numérique à une table de consultation, la table de consultation fournissant en sortie la première valeur numérique et la deuxième valeur numérique en fonction de la troisième valeur numérique ;

utiliser le circuit d'attaque de données (120) pour recevoir et convertir les première et deuxième valeurs numériques en des première et deuxième tensions, dans lequel la première tension est telle que, si elle est appliquée à une anode de la diode électroluminescente organique, elle compense la dégradation de la diode électroluminescente organique en correspondance avec un premier niveau de luminance prédéterminé, et la deuxième tension est telle que, si elle est appliquée à l'anode de la diode électroluminescente organique, elle induise un deuxième courant prédéterminé en correspondance avec un deuxième niveau de luminance prédéterminé, et pour générer des signaux de données correspondant à des deuxièmes données pendant une période d'attaque normale ;

utiliser l'amplificateur opérationnel (200) pour chaque ligne de données comprenant une première borne d'entrée, une deuxième borne d'entrée, et une borne de sortie connectée à la ligne de données destinée au pixel, l'amplificateur opérationnel (200) recevant sur la première borne d'entrée la première tension lors du premier intervalle et la deuxième tension lors du deuxième intervalle, la deuxième borne d'entrée étant connectée à la ligne de rétroaction du pixel et à l'amplificateur opérationnel (200) recevant la sortie de la ligne de rétroaction du pixel lors de la deuxième période, le commutateur (M4) étant commandé pour être commuté à l'état passant lors de la deuxième période, et le transistor de commande d'émission (M3) étant commandé pour être commuté l'état non passant lors de la première période et pour être commuté à l'état passant lors de la deuxième période, et la borne de sortie étant connectée à une électrode de grille du transistor d'attaque du pixel ;

utiliser le premier convertisseur analogique-numérique (180) pour recevoir et convertir la tension appliquée à l'électrode de grille du transistor d'attaque lors du premier intervalle en une quatrième valeur numérique, et pour recevoir et convertir la tension appliquée à l'électrode de grille du transistor d'attaque lors du deuxième intervalle en une cinquième valeur numérique ; et

utiliser l'unité de commande de cadencement (150) pour stocker la quatrième valeur numérique et la cinquième valeur numérique, et pour modifier des premières données délivrées de l'extérieur en fonction de la quatrième valeur numérique et de la cinquième valeur numérique afin de générer les deuxièmes données pour compenser la dégradation de la diode électroluminescente organique, et une mobilité et une tension de seuil du circuit d'attaque.

13. Procédé selon la revendication 12, dans lequel une valeur de courant de la source de courant est comprise entre environ 50 nA et environ 50 pA.

14. Procédé selon la revendication 12 ou 13, dans lequel la première tension est une tension devant être appliquée à l'électrode d'anode de la diode électroluminescente organique pour exprimer la luminance d'une gradation maximale indépendamment des informations de dégradation de la diode électroluminescente organique.

15. Procédé selon la revendication 14, dans lequel la deuxième tension est une tension devant être appliquée à l'électrode d'anode de la diode électroluminescente organique pour que la diode électroluminescente organique génère une quatrième luminance d'une gradation maximale ou qu'elle génère une luminance d'une gradation minimale.

# FIG. 1
## (PRIOR ART)

# FIG. 2

# FIG. 3

# FIG. 4

<u>120</u>

SSP →
SSC →
    1211  1212  1213  1214                    121m
    Shift register unit · · ·                    ~121

        1221 1222 1223 1224              122m

Data2 →
    Sampling latch unit · ·                    ~122

        1231 1232 1233 1234              123m

SOE →
    Holding latch unit · · ·                    ~123

        1241 1242 1243 1244              124m

    Signal generator · · ·                    ~124

        1251 1252 1253 1254              125m

    Buffer unit · · ·                    ~125

· · ·

D1    D2    D3    D4              Dm

# FIG. 5

EP 2 026 319 B1

# FIG. 6A

Sensing period | Normal drive period

First period | Second period

DS1
DS2
DS6
DS8
DS7
DS3
DS4
Cm
DS5
Sn
En

# FIG. 6B

# FIG. 6C

EP 2 026 319 B1

# FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006063448 A
- US 20030057895 A
- EP 0905673 A
- US 2003057895 A